Europäisches Patentamt

European Patent Office

Office européen des brevets

(19)

(11) Publication number: **0 206 717**
**A2**

# EUROPEAN PATENT APPLICATION

(12)

(21) Application number: **86304623.1**

(22) Date of filing: **16.06.86**

(51) Int. Cl.⁴: **C 04 B 28/24, C 04 B 41/87**

(30) Priority: **17.06.85 JP 131542/85**
**01.11.85 JP 245835/85**

(43) Date of publication of application: **30.12.86**
**Bulletin 86/52**

(84) Designated Contracting States: **DE FR GB**

(71) Applicant: **NISSAN CHEMICAL INDUSTRIES LTD., 3-7-1, Kanda Nishiki-cho, Chiyoda-ku Tokyo (JP)**

(72) Inventor: **Okubi, Kenichi c/o Nissan Chemical Ind. Limited, of Central Research Institute 722-1 Tsuboi-cho, Funabashi City Chiba Prefecture (JP)**
Inventor: **Tsugeno, Makoto c/o Nissan Chemical Ind. Limited, of Central Research Institute 722-1 Tsuboi-cho, Funabashi City Chiba Prefecture (JP)**
Inventor: **Nogami, Tatsuya c/o Nissan Chemical Ind. Limited, of Central Research Institute 722-1 Tsuboi-cho, Funabashi City Chiba Prefecture (JP)**
Inventor: **Takei, Takashi c/o Nissan Chemical Ind. Limited, of Central Research Institute 722-1 Tsuboi-cho, Funabashi City Chiba Prefecture (JP)**
Inventor: **Tasaki, Kieko c/o Nissan Chemical Ind. Limited, of Central Research Institute 722-1 Tsuboi-cho, Funabashi City Chiba Prefecture (JP)**

(74) Representative: **Funge, Harry et al, M'CAW & CO. 41-51 Royal Exchange Cross Street, Manchester M2 7BD (GB)**

(54) **Coating compositions.**

(57) Coating or binding agent to be used for paints, adhesives etc. and for coating molds, ceramic and metallic articles, above all ceramic substrates for I.C., having practically sufficient storage stability and being able to form transparent and hard film on substratum surface readily by drying and provide calcinated film without causing any cracking.

Such composition is obtained by reacting an organic silica of 5-200 m$\mu$ particle size dispersed in an organic solvent in 1-50 weight % as $SiO_2$, in the amount of 100 parts by weight as $SiO_2$; an alkyl silicate in the amount of 20-200 parts by weight as $SiO_2$; and water in the amount of 0.5-7.0 mol relative to 1 gram atom of silicon in said alkyl silicate.

- 1 -

## COATING COMPOSITIONS

The invention relates to an improvement of a coating or binding composition comprising silica and an organic solvent as dispersant, which may be used for paints, adhesives and the like and for coating molds, ceramic and metallic articles above all ceramic substrates for the integrated circuit.

Silica-sol which is a dispersion system of silica particles in liquid medium has been used for various purposes referred to above. Either of aqueous silica-sol and organosilica- sol in which an organic solvent is used as the dispersant may irreversibly be hardened by excluding the medium therefrom so that colloidal silica particles are bonded to one another. Silica-sol has been used, thus, as coating material or binder owing to said property.

Aqueous silica-sol has been improved and widely used. Aqueous silica-sol is, however, still unsatifactory in that the binding ability thereof is relatively not so good and consequently the hardened layer can not be so strongly adhered to the substratum to be sometimes peeled off. It is noted also that aqueous silica-sol can not be applied to a substratum not water-resisting and it takes a relatively long time for drying which naturally restrict the use thereof.

In lieu thereof or for compensation therefor organosilica-sol has also fairly widely been used. Above all, stable organosilica-sol obtained according to the method in which water as the dispersant for aqueous silica-sol is subjected to distillation

- 2 -

substitution with an organic solvent is well-known but still unsatisfactory in that the hardened layer is poor in adhesiveness to the substratum. The binder of said nature which is obtained by subjecting alkyl silicate to hydrolysis to be condensated, which is superior in faster driability and higher adhesiveness to the substratum but unsatisfactory in storage stability and readily ocurring of cracking in the coated film.

In order to improve the binder of such silica-sol, for instance Japanese Patent Application Gazette Opened For Public Inspection (KOKOKU) under the number of 48 (1973)-32482 proposes a binder comprising silica and an organic solvent as dispersant but no water content which is obtained by mixing aqueous silica-sol with an alkyl silicate which is hydrolyzed with water content in said aqueous silica-sol. Such binder has not been practically used by reasons of that $SiO_2$ content derived from aqueous silica-sol is restricted, mol-ratio of water to decompose alkyl silicate is made naturally larger, and the binding ability as well as the storage stability is not so good.

Japanese Patent Application Gazette Opened For Public Inspection (KOKOKU) under the number of Sho 54 (1979)-40366 proposes a binder of improved storage stability comprising glycol ether colloidal silica and the hydrolyzed product of alkyl silicate as mixture, which is also unsatisfactory in binding ability.

In general, when forming a coated film on the substratum with silica binder or coating material of poor binding ability, particularly when calcinating at a high temperature in the order of 500°C, cracking is

- 3 -

apt to be caused, even if the formed film thickness is fairly thin. According to the conventional silica-sol as referred to above, the coated film of thickness thicker than $0.3\mu$ cracking is to be caused.

Meanwhile, ceramic substrates for the integrated circuit are manufactured by preparing green sheets of pulverized ceramics and then calcinating the same. The product substrate has a rough surface which must be coated with a suitable material to be smooth, since the integration degree has rapidly been increased and the thickness of the circuit has considerably been made fine.

In the past the surface of such substrate was polished but this is unsatisfactory since not only the sufficiently necessary smooth surface can not be obtained but also there is sometimes resulted in pin-holes and the efficiency is not so good.

Recently, thus, three methods are proposed, in which the first is using of pulverized ceramics material of which particle size distribution is adjusted, the second is applying of glaze on the substrate surface and then calcinating, and the third is coating of a solution of oligomer obtained by subjecting an alkoxysilane, drying and calcinating as disclosed in Japanese Patent Application Gazette Early Opened (KOKAI) under the number of Sho 60(1985)-112683, all of which, however, are not satisfactory.

In the first method particles must be classified and mixed well so as to attain uniform size distribution, and that the smoothness of the substrate surface is still not sufficient for the recent integrated circuit. According to the second method, the surface

- 4 -

smoothness is fairly satisfactory but the calcination at a high temperature of 700° - 800°C is necessary and as a result thereof there are often caused pin-holes or waved corrugations. The formed glaze layer is generally of 10 $\mu$ thickness which deteriorates or harms properties of the ceramic substrate. Said third method is fairly satisfactory in that the calcination can be carried out easily and at a lower temperature but the smoothness of the surface is not sufficient and the storage stability is not so good that quality of calcinated coating films is not always constant.

As well known to those skilled in the art, the ceramic substrate for the integrated circuit is excellent in electric insulativeness, mechanical strengthes, adhesiveness to conductive lines, durability to chemicals, thermal conductivity and the like. Even if a desired smoothness can be realized, the coating agent to possibly jeopardize said preferable properties can not actually be utilized.

Difficulty in improving the coating material for the ceramic substrate lies in forming sufficiently smooth and homogeneous layer on the surface thereof without damaging desirable properties of the ceramic substrate.

## SUMMARY OF THE INVENTION

An object of the invention is, thus, to provide a coating or binding composition comprising silica and an organic solvent as dispersant, which has practically sufficient storage stability and can form transparent and hard film on the substratum surface readily by

- 5 -

drying and provide calcinated film without causing any cracking even if considerably thick and strongly adhered to the substratum.

The other object according to another aspect of the invention is to provide a ceramic substrate applied with said composition so as to readily and efficiently form a coating film of high homogeneousness, smoothness and hardness without jeopardizing desirable properties thereof.

Said objects and various advantages to be appreciated by studying the following explanation may be attained fundamentally according to a coating composition of the invention to be obtained by reacting an organosilica-sol, which contains colloidal silica of 5 - 200 m$\mu$, and more particularly of 50 - 100 m$\mu$, particle size dispersed in an organic solvent in the amount of 1 - 50 weight % as $SiO_2$, in the amount of 100 parts by weight as $SiO_2$; an alkyl silicate in the amount of 20 - 200 parts by weight as $SiO_2$; and water in the amount of 0.5 - 7.0 mol relative to 1 gram atom of silicon in said alkyl silicate.

DETAILED EXPLANATION OF PREFERED EMBODIMENTS

An organic solvent to be used for the organosilica-sol in the invention as dispersant is an alcohol such as methanol, ethanol, isopropanol and butanol; a ketone such as acetone, methyl ethyl ketone and methyl isobutyl ketone; an ester such as methyl acetate, ethyl acetate and butyl acetate; an ether such as diisopropyl ether and glycol ether e.g. methyl, ethyl,

- 6 -

propyl and butyl cellosolves; an aliphatic hydrocarbon such as hexane and heptane; and an aromatic hydrocarbon such as benzene, toluene and xylene as well as any mixture thereof.

Said organosilica-sol may be prepared by any known method. For instance an aqueous silica-sol of colloidal silica having 5 - 200 m particle size is added with said organic solvent so as to distillatingly substitute. The amount of said colloidal silica in the dispering organosilica-sol preferably ranges from 5 to 50 weight % as $SiO_2$. The particle size more preferably ranges from 50 to 100 m$\mu$.

The alkyl silicate to be used in the invention is preferably a tetraalkyl orthosilicate of which alkyl has a straight or branched chain and 1 - 4 carbon atoms, or an alkyl polysilicate which is a condensate of the above and has a condensation degree of less than about 10 or a mixture thereof, among which tetramethyl orthosilicate, tetraethyl orthosilicate, tetra-n-propyl orthosilicate, tetra-i-propyl orthosilicate, tetra-n-buthyl orthosilicate, tetra-sec-butyl orthosilicate, methyl polysilicate, and ethyl polysilicate are exemplified. Above all Ethyl Silicate 40 which is a mixture of tetraethyl orthosilicate and ethyl polysilicate and contains 40 weight % $SiO_2$ is preferable.

The reaction of the organosilica-sol as referred above and the alkyl silicate as referred to above with water in the amount of 0.5 - 7.0 mol per a gram atom of silicon contained in said alkyl silicate is carried out, as occasion demands with addition of the organic solvent for dilution, at a temperature below 200°C,

- 7 -

preferably ranging from the room temperature to about 150°C, more paricularly from 40°C to the boiling point of the solvent, and at the atmospheric. Said reaction may be carried out at a relatively low temperature in the former stage and at a relatively high temperature in the latter stage.

Said reaction may be accelerated by adding a catalyst, among which there are an inorganic acid such as hydrochloric acid, sulfuric acid, nitric acid, phosphoric acid and boric acid; an organic acid such as formic acid, acetic acid, oxalic acid, benzoic acid, methanesulfonic acid and paratoluenesulfonic acid; a hydrogenic cation exchange resin; a metal halide as well as inorganic and organic acid salts, and any mixture thereof. The amount of the catalyst to be added preferably ranges from 0.05 to 5 mol % in respect of silicon contained in said alkyl silicate. Various catalysts may be added one by one in each of devided steps of the reaction.

In addition to the above reactants, any other additive may be added before, during and after the reaction so far as the desired composition of the invention can be obtained.

The desired composition according to the invention can be obtained by using said organosilica-sol and alkyl silicate in such an amount that $SiO_2$ content therein is less than 50 weight %, preferably 35 weight %, More preferably the amount of the alkyl silicate is so adjusted that $SiO_2$ content derived therefrom ranges from 0.1 to 15 weight %, and more particuraly from 1 to 10 weight %.

In order to easily control the reaction, it is preferable to divide the reaction into a plurality of stages so that the temperature, the sort and amount of the catalyst to be added and other reaction conditions are varied in every stage. Furthermore it is also possible in order to adjust the $SiO_2$ content to add the solvent or remove the same by distillation during the reaction or proceed with the reaction with azeotropically distilling off water exsisting in the reactant.

When the alkyl silicate is reacted with water, a silicon compound having a silanol radical and an alkanol or alkylarylsulfonate are formed in the reaction system. Said silicon compound has a varied number of silanol radical to be bonded with a silicon atom depending on the amount of reacted water. The silanol radical has a considerably high reactivity so that the reaction between the silanol radicals or with an alcoxy occurs to produce the siloxane bond. This siloxane bond forming reaction may be said consendation reaction.

A conventional organosilica-sol obtained by subjecting the alkyl silicate to hydrolysis in the presence of the acidic catalyst is a dispersing system of very fine colloidal silica particles formed through said silanol radical forming reaction and the condensation reaction.

Even if such conventional organosilica-sol as obtained by subjecting the alkyl silicate is or further the mixture is heated mixed with the organosilica-sol referred to above, it is impossible to prepare the improved coating or binding agent of the invention. Only when the organosilica- sol and the alkyl silicate respectively referred to above are reacted with water in the respective amounts as referred to above, the considerably improved product can be obtained.

The reason has not yet been made clear but it is considered at the present that the silanol radical, which is formed by the reaction of the alkyl silicate with water reacts with an active group on the particle surface of colloidal silica in the organosilica-sol to proceed with the condensation reaction of silanol radical to form a new siloxane bond.

When the particle size of colloidal silica in the organosilica-sol is smaller than 5 m$\mu$, cracking is apt to occur when calcinating the coated film, while if said size is larger than 200 m$\mu$, film forming ability is poor and the hardness of the calcinated film is low.

When the amount of the alkyl silicate to be subjected to the reaction is more than 200 weight parts as $SiO_2$ in relation to the organosilica-sol to be used in the amount of 100 weight parts as $SiO_2$, the binding ability of the reaction product can not be improved and consequently cracking is apt to occur in the calcinated coating film. Contrally if the amount of said alkyl silicate is less than 20 weight parts as $SiO_2$ relative to 100 weight parts $SiO_2$ derived from the organosilica-sol, the calcinated coating film is unsatisfactorily poor in the hardness and adhesiveness with the substratum.

When the amount of water to be used for the reaction is less than 0.5 mol per a gram atom of silicon in the used alkyl silicate, the film forming

- 10 -

ability of the reaction product is poor and the hardness as well as the transparencity of the died film are undesiredly low. In contrast therewith when the amount of water is more than 7 mol per a gram atom of silicon in the used alkyl silicate, the stability of the reaction product is considerably lowered.

As for the particle size of silica in the organosilica-sol, when using the range of 5 - 200 m$\mu$, and more preferably 50 - 100 m$\mu$, cracking will not occur even if the calcinated coating film is considerably thick, say thicker than 0.6$\mu$ in comparison of the maximum thickness of 0.3$\mu$ of the prior art, and the hardness as well as the adhesiveness are quite satisfactory.

It is noted that the reaction should be advanced not so fast in order to avoid gelation of the reaction system. Even if said gelation does not occur during the reaction, it does in a short time of storage. Above all the reaction at a temperature above 200°C, not only gelation is apt to occur but also the storage stability is considerably lowered.

When the amount of the catalyst to be added as occasion demands is more than 5 mol % relative to silicon contained in the alkyl silicate, the surface smoothness and the compactness of the formed film are apt to be jeopardized.

The coating film formed on the substratum surface contains a volatile content comprising the solvent, which is evaporated by drying following to applying of the coating composition on the substratum. In order to accelerate the evaporation, drying treatment is carried out at a higher temperature, but when drying

- 11 -

at an excessively high temperature violent movement of the volatile content in the film jeopardizes homogeneousness and surface smoothness of the coating film. The drying temperature is preferably below 250°C, and more preferably ranges from 50 to 200°C. Calcinating of the film too early before the complete drying also jeopardizes the homogeneousness and smoothness.

There is an alkoxy group bonded with a silicon atom in the dried coating film but said alcoxy group is freed by calcination following to the drying treatment so that the film is formed by silica bond system. When calcinating at an excessively high temperature in order to accelerate said drying treatment, not only the energy is uselessly consumed but also the cracking as well as the exfoliation of the film are apt to occur. The time of calcination ranges preferaly from 10 to 150 minutes.

Application of the coating agent as referred to on the ceramic substrate according to the invention can be made by any of the known methods, for instance the impregnating method, the spinner method in which the substrate mounted on a rotating member on which the coating agent is dropped, spraying, rolling and brushing methods. In order to obtain homogeneous coating film, said impregnation and spinner methods are particularly preferable.

Drying may be done by any of the conventional methods, for instance natural drying and compulsive drying. Calcinating can be done also by the usual methods such as electric furnace heating. The temperature may be varied depending on the sort of the

- 12 -

substrate, but in general is higher than 250°C and preferably than 350°C. The calcinating time ranges from several minutes to several hours, preferably from 10 to 150 minutes to be varied depending on the film thickness, the ingredients and the like.

The coating agent of the invention may be applied preferably on various ceramic substrates. Among the ceramics, there are alumina, berylia, magnesia, mullite, stealite, forsterite, porcelain enamelled, silicon nitride, aluminum nitride and silicon carbide.

The invention will be explained in more detail in the following Examples.

Example 1

A 2 litres reactor flask provided with a thermometer, a dropping funnel, a stirrer and a reflux condenser was charged with 208g tetraethyl orthosilicate and 404g ethanol, to which a mixture of 333g methanol silica-sol obtained according to the distillation substitution ($SiO_2$ concentration of 30%, particle size of 70 - 100 m$\mu$), 54g water and 1g concentrated hydrochloric acid was dropwise added with stirring within 15 minutes during which the temperature of the reactant liquid was raised from 20°C upto 29°C due to the exothermic reaction. By further proceeding with the reaction in the oil bath at the reflux temperature of the solvent, namely 72°C for 5 hours, the coating agent was obtained which contains 16 weight % $SiO_2$, 6 weight % derived from the alkyl silicate and 10 weight % from the organosilica-sol.

Example 2

An 1 litre reactor flask provided with a thermometer, a dropping funnel, a stirrer and a reflux

- 13 -

condenser was charged with 120g Ethyl Silicate 40 (Trade Name, By Colcoat) and 388g ethanol, to which a mixture of 267g methanol silica-sol obtained according to the distillation substitution ($SiO_2$ concentration of 30%, particle size of 10 - 20 m$\mu$), 24.8g water and 0.8g concentrated hydrochloric acid was dropwise added with stirring within 30 minutes during which the reactant liquid temperature was raised from 20°C upto 25°C. After completion of the dropping addition, the reaction was further carried out in the oil bath at the reflux temperature of the solvent for 3 hours so as to obtain the coating composition containing 16 weight % $SiO_2$, in which 6 weight % was derived from the alkyl silicate while 10 weight % was from the organosilica-sol.

Example 3

In a similar 1 litre reactor falsk, the reaction was carried out similar to Example 1 but with using 104g tetraethyl orthosilicate, 35g ethanol, 27g water and 0.5g concentrated hydrochloric acid at the reflux temperature of the solvent, namely 66°C for 3 hours to obtain the coating composition containing 26 weight % $SiO_2$, in which 6 weight % was derived from the alkyl silicate while 20 weight % was from the organosilica-sol.

Example 4

A 300 ml reactor flask similarly provided with a thermometer, a dropping funnel, a stirrer and a reflux condenser was charged with 38g tetramethyl orthosilicate and 114g ethanol, to which a mixture of 83.3g methanol silica-sol obtained according to the distillation substituion ($SiO_2$ concentration of 30%, particle size of 70 - 100 m$\mu$), 13.5g water and 1.6g of oxalic acid

- 14 -

was dropwise added with stirring under reflux within 30 minutes. After completion of the dropping addition, the reaction was continued at the same temperature for further 2.5 hours to obtain the coating composition containing 16 weight % $SiO_2$ in which 6 weight % was derived from the alkyl silicate while 10 weight % was from the organosilica-sol.

Example 5

A 200 ml reactor flask similarly provided with a thermometer, a dropping funnel, a stirrer and a reflux condenser was charged with 20.8g tetraethyl orthosilicate and 40.4g ethanol with stirring, to which a mixture of 33.3g methanol silica-sol obtained according to the distillation substitution ($SiO_2$ concentration of 30%, particle size of 10 - 20 m$\mu$), 5.4g water and 0.1g concentrated hydrochloric acid was dropwise added within 30 minutes, during which the reactant liquid temperature rised from 18°C upto 27°C. After completion of the dropping addition, the reaction was continued in the oil bath at the reflux temperature of the solvent for 3 hours to obtain the coating composition containing 16 weight % $SiO_2$, in which 6 weight % was derived from the alkyl silicate while 10 weight % was from the organosilica-sol.

Examples 6 - 8

The reactions were carried out similar to Example 5 but with using methanol silica-sol as shown in following Table 1 to obtain the coating agents as shown therein.

- 15 -

Table 1

| Expl. | Methanol Silica-sol | | SiO$_2$ Concentration In Coating Agent (5) | | |
| | Particle Size (mμ) | SiO$_2$ Conc. (%) | Alkyl Silicate | Organo Silica-sol | Total |
|---|---|---|---|---|---|
| 6 | 7 - 9 | 30 | 6 | 10 | 16 |
| 7 | 40 - 50 | 30 | 6 | 10 | 16 |
| 8 | 150 -170 | 30 | 6 | 10 | 16 |

Example 9

According to the process similar to Example 5 but with using a mixture of methanol silica-sols A and B shown in Table 2 to obtain the coating agent as shown therein.

Table 2

| Methanol Silica-sol A | | | Methanol Silica-sol | | | SiO$_2$ Concentration In Coating Agent (%) | | |
|---|---|---|---|---|---|---|---|---|
| Patcl. Size (m/$\mu$) | SiO$_2$ Conc. (%) | Amount (g) | Patcl. Size (m/$\mu$) | SiO$_2$ Conc. (%) | Amount (g) | Alkyl Silicate | Methanol Silica-sol | Total |
| 10-20 | 30 | 11.1 | 70-100 | 30 | 22.2 | 6 | 10 | 16 |

0206717

- 17 -

Examples 10 - 11

According to the process similar to Example 5 but with using organosilica-sol dispersed in organic solvents showin in Table 3 instead of methanol silica-sol, the coating agents as shown therein were obtained.

Examples 12 - 15

An 200 ml reactor flask provided with a thermometer, a dropping funnel, a stirrer and a reflux condenser was charged with 20.8g tetraethyl orthosilicate, 40.4g ethanol and 33.3g organosilica-sol as shown in Table 3, to which a mixture of 5.4g water and 0.1g concentrated hydrochloric acid was dropwise added with stirring. After completion of the dropping addition, the reaction was continued in the oil bath at the reflux temperature of the solvent for 3 hours to obtain the coating agents as shown in said Table.

Table 3

| Expl. | Organosilica-sol | | | SiO$_2$ Concentration In Coating Agent | | |
| | Dispersant | Patcl. Size (m/$\mu$) | conc. SiO$_2$ (%) | alkyl Silicate | Organo-Silica-sol | Total |
|---|---|---|---|---|---|---|
| 10 | n-Propanol | 10 - 20 | 30 | 6 | 10 | 16 |
| 11 | Methyl-i-Butyl Ketone | 10 - 20 | 30 | 6 | 10 | 16 |
| 12 | Ethyl Cellosolve | 10 - 20 | 30 | 6 | 10 | 16 |
| 13 | Butyl Acetate | 10 - 20 | 30 | 6 | 10 | 16 |
| 14 | n-Buthanol | 10 - 20 | 30 | 6 | 10 | 16 |
| 15 | Xylene | 10 - 20 | 30 | 6 | 10 | 16 |

0206717

- 19 -

### Examples 16 - 17

According to the process similar to Example 5 but with using the catalysts as shown in Table 4 instead of concentrated hydrochloric acid, the coating compositions as shown therein were obtained.

Table 4

| Expl. | Catalyst | | Concentration Of $SiO_2$ In Coating Composition (%) | | |
| | Sort | Amount (g) | Alkyl Silicate | Organo-Silica-sol | Total |
|---|---|---|---|---|---|
| 16 | Sulfuric Acid | 0.2 | 6 | 10 | 16 |
| 17 | p-Toluene Sulfonic Acid | 1.0 | 6 | 10 | 16 |

### Examples 18 - 20

An 1 litre reactor flask was charges with 104g tetraethyl orthosilicate and 202g ethanol to which a mixture of 167 methanol silica-sol obtained according to the destillation substitution ($SiO_2$ concentration of 30%, particle size of 10 - 20 m$\mu$), 27g water and 0.5g concentrated hydrochloric acid was dropwise added with stirring. Each 100g reaction mixture was further reacted in the conditions as shown in Table 5 according to Examples 18 - 20 to obtain respective coating compositions. It is added that Examples 19 and 20 were carried out respectively in the sealed reactor made of the fluorine-contained resin.

- 20 -

Table 5

|  |  | Reaction Conditions |  | Concentration Of $SiO_2$ In Coating Composition (%) | | |
|---|---|---|---|---|---|---|
| Expl. | Temp. (°C) | Pressure | Hour (hr) | Alkyl Silicate | Methanol Silica-sol | Total |
| 18 | 70 | Atmospheric | 10 | 6 | 10 | 16 |
| 19 | 100 | Autogeneous | 2 | 6 | 10 | 16 |
| 20 | 120 | " | 2 | 6 | 10 | 16 |

Examples 21 - 24

According to the process similar to Example 5 but in the amounts of ethanol solvent and water as shown in Table 6, the coating compositions were obtained according to Examples 21 - 24 respectively containing 16 weight % $SiO_2$, in which 6 weight % was derived from the alkyl silicate while 10 weight % was from the organosilica- sol.

Table 6

| Expl. | Ethanol Amount (g) | Water Amount (g) | Mol Ratio Of $H_2O$ To Si in Alkyl Silicate |
|---|---|---|---|
| 21 | 44.0 | 1.8 | 1.0 |
| 22 | 43.1 | 2.7 | 1.5 |
| 23 | 40.4 | 5.4 | 3 |
| 24 | 36.8 | 9.0 | 5 |

Examples 25 - 26

According to the process similar to Example 5 but

- 21 -

with using 15.0g Ethyl Silicate 40 (cf. the above) instead of tetraethyl orthosilicate and in the amounts of ethanol and water as shown in Table 7, the coating compositions respectively containing 16 weight %, in which 6 weight % was derived from the alkyl silicate while 10 weight % was from the organosilica-sol.

Table 7

| Expl. | Ethanol Amount (g) | Water Amount (g) | Mol Ratio Of $H_2O$ To Si In Alkyl Silicate |
|-------|--------------------|--------------------|---------------------------------------------|
| 25    | 50.7               | 0.9                | 0.5                                         |
| 26    | 49.8               | 1.8                | 1.0                                         |

Examples 27 - 28

An 200 ml reactor flask provided with a thermometer, a dropping funnel, a stirrer and a reflux condenser was charged with 20.3g tetraethyl orthosilicate and 26.3g ethanol, to which a mixture of 45.5g methanol silica-sol obtained according to the distillation substitution ($SiO_2$ concentration of 30%, particle size of 70 - 100 m$\mu$) 5.2g water and 0.1g concentrated hydrochloric acid was dropwise added with stirring within 15 minutes to obtain the coating composition as Example 27. The reaction was continued in the oil bath for further 3 hours at the reflux temperature of the solvent to obtain the coating composition as Example 28. Either of said two coating compositions contained 20 weight % $SiO_2$, in which 6 weight % was derived from the alkyl silicate while 14 weight % was from the organosilica-sol.

Examples 29 - 35

- 22 -

According to the process similar to Example 5 but with using methanol silica-sol containing 30% concentration of $SiO_2$ as shown in Table 8 and ethanol in the amounts as shown therein to obtain respective coating compositions as Examples 29 - 35.

Table 8

| Expl. | Methanol Silica-sol | | Ethanol Amount (g) | $SiO_2$ Concentration In Coating Composition (%) | | |
|---|---|---|---|---|---|---|
| | Partcl. Size(m/$\mu$) | Amount (g) | | Alkyl Silicate | Methanol Silica-sol | Total |
| 29 | 10 - 20 | 60 | 214 | 2 | 6 | 8 |
| 30 | 10 - 20 | 100 | 174 | 2 | 10 | 12 |
| 31 | 40 - 50 | 30 | 94 | 4 | 6 | 10 |
| 32 | 70 - 100 | 60 | 14 | 6 | 18 | 24 |
| 33 | 10 - 20 | 10 | 39 | 8 | 4 | 12 |
| 34 | 70 - 100 | 25 | 24 | 8 | 10 | 18 |
| 35 | 70 - 100 | 30 | 19 | 8 | 12 | 20 |

0206717

- 24 -

Examples 36 - 37

According to the process similar to Example 5, the coating compositions respectively containing 16 weight % $SiO_2$ were obtained, which were diluted with ethanol in the amounts as shown in Table 9 to obtain the coating agents as Examples 36 and 37.

Table 9

| Expl. | Ingredients | | | $SiO_2$ Concentration In Coating Composition (%) | | |
|---|---|---|---|---|---|---|
| | Amount of Coating Agent of Expl.5 (g) | Ethanol (g) | Total | Alkyl Silicate | Methanol Silica-sol | Total |
| 36 | 10 | 90 | 100 | 0.6 | 1.0 | 1.6 |
| 37 | 2.5 | 97.5 | 100 | 0.15 | 0.25 | 0.4 |

Example 38

A 2 litres reactor flask provided with a thermometer, a dropping funnel, a stirrer and a reflux condenser was charged with a 208g tetraethyl orthosilicate and 53g ethanol, to which a mixture of 680g ethanol silica-sol ($SiO_2$ concentration of 15%, mean particle size of 100 m$\mu$, trade name "Quartron PL-10" by Tonen Sekiyu Kagaku K.K.), 54g water and 5g concentrated hydrochloric acid was dropwise added with stirring within 20 minutes, during which the reactant liquid temperature was raised from 24°C to 32°C.

After completion of the dropping addition, the reaction was continued in the oil bath at the reflux temperature of the solvent for further 2 hours to obtain the coating composition containing 16 weight %

- 25 -

$SiO_2$, in which 6 weight % was derived from the alkyl silicate while 10 weight % was from the organosilica-sol.

### Comparative Experiment 1

To a mixture of 104g tetraethyl silicate and 46g ethanol, a mixture of 27g water, 0.5g concentrated hydrochloric acid and 23g ethanol was dropwise added with stirring at the room temperature within 30 minutes to obtain the reaction product containing 15 weight % $SiO_2$.

### Comparative Expariments 2 - 3

The reaction product obtained in said Experiment 1 as the coating agent in the amount of 50g was diluted with 25g ehtanol to prepare the control coating agent containing 10 weight % $SiO_2$ as Experiment 2 and diluted with 75g ethanol to prepare the control coating agent containing 6 weight % $SiO_2$ as Experiment 3.

### Comparative Experiment 4

By dropwise adding methanol to an aqueous silica-sol containing 30 weight % $SiO_2$ so as to distillatingly substitute water with methanol and obtain 150g methanol silica-sol which was diluted with 75g methanol to obtain the coating agent containing 20 weight % $SiO_2$.

### Comparative Experiments 5 - 6

By mixing 32g coating agent obtained in Experiment 1 and 26.6g coating agent of Experiment 4 containing 30 weight % $SiO_2$ together with 21.4g ethanol at the room temperature, the control coating agent containing 16 weight % $SiO_2$ was obtained as Experiment 5.

Said coating agent of Experiment 5 was heated at the reflux temperature of the solvent for 3 hours to obtain the control coating agent as Experiment 6.

- 26 -

Comparative Experiments 7 - 8

Concentrated hydrochloric acid in the amount of 0.83g was added to a stable aqueous silica-sol of pH 9.2 ($SiO_2$ concentration of 44.5 %, particle size of 10 - 20 m$\mu$) in the amount of 42.3g. After the mixing for 5 minutes, 167.4g ethanol was added thereto. By finally adding 109.8g Ethyl Silicate 40 (marketed by Colcoat) to be mixed for 2 hours, the control coating agent containing 20 weight % $SiO_2$ was obtained as Experiment 7.

To 75g coating agent of Experiment 7, 25g ethanol was added so as to obtain the control coating agent containing 15 weight % $SiO_2$ as Experiment 8.

Comparative Experiments 9 - 11

To a liquid mixture of 80.56 ml Ethyl Silicate 40 (see the above) and 18.54 ml ethyl cellosolve, a liquid mixture of 12.4 ml water and 2.5 ml concentrated sulfuric acid was added.

Said liquid mixture was added to 886 ml ethyl cellosolve silica-sol containing 30 weight % $SiO_2$ so as to obtain the control coating agent as Experiment 9.

Said control agnet was diluted with ethyl cellosolve to obtain the control agent containing 15 weight % $SiO_2$ as Experiment 10 and that containing 12 weight % $SiO_2$ as Experiment 11.

Comparative Experiment 12

According the process similar to Example 5 but with using 27.8g ethanol and 18.0g water (mol ratio of $H_2O$ to Si in the alkyl silicate 10.0) different therefrom, the coating agent containing 16 weight % $SiO_2$ was obtained as control.

Test A

- 27 -

Slide glass substrates (26 mm x 76 mm x 1 mm) were dipped in the coating agents of Examples 1 - 35 and in the controls of Comparative Experiments 1 - 12 in the air conditioned room set at a temperature of 20°C and a relative humidity of 50% and taken up by the taking up device at a constant rate so as to form a coating film on the respective substrate.

After leaving to stand still one night, said glass substartes respectively formed with the coating film were subjected to provisional heating in the drying chamber at 100°C for 30 minutes and then calcinated in the electric furnace at 500°C for 30 minutes.

Said substrates were gradually cooled down to the room temperature so as to examine properties, thickness, anti-cracking, hardness and adhesiveness to the substrate of the formed film. The results in respect of Examples 1- 28 are given in Table 10, in which respective symbols mean the followings;

Properties of Formed Film

0 ..... Good in film formability and transparency, and no color change (whitened, yellowed)

△ ..... Inferior a little to the above in any item

x ..... Considerably inferior in any item or impossible to maintain film formation due to cracking

Thickness

The thickness of the calcinated film was determined by drawing a line in the film with a steel needle immediately after formation thereof and measuring with the surface roughness tester after the calcination at 500°C. As to the glass substrates of which film thickness can not be determined by said roughness

- 28 -

tester due to cracking and so on, the thickness was determined by the difference of the weight before and after formation of the film and the coated area.

Anti-cracking

⊚ ..... No cracking

○ ..... Almost no cracking

△ ..... Some cracking

x ..... Considerably much cracking

Hardness

○ ..... No streak caused by scratching with a steel needle

△ ..... Some streak caused by scratching with a steel needle

x ..... Considerably definite streak caused by scratching with a steel needle

Adhesiveness

○ ..... Satisfactorily adhered to the substrate

△ ..... Some exfoliation caused by scratching with a steel needle

x ..... Considerably much exfoliation caused by scratching with a steel needle

Table 10

| Expl. No. | Properties of Formed Film | Thickness (μ) | Anti-cracking | Hardness | Adhesive-ness |
|---|---|---|---|---|---|
| 1 | ○ | 0.78 | ◎ | ○ | ○ |
| 2 | ○ | 0.70 | ○ | ○ | ○ |
| 3 | ○ | 1.25 | ◎ | ○ | ○ |
| 4 | ○ | 0.80 | ◎ | ○ | ○ |
| 5 | ○ | 0.78 | ○ | ○ | ○ |
| 6 | ○ | 0.74 | ○ | ○ | ○ |
| 7 | ○ | 0.74 | ○ | ○ | ○ |
| 8 | ○～△ (Slightly Cloudy) | 0.91 | ◎ | △ | ○ |
| 9 | ○ | 0.75 | ◎ | ○ | ○ |
| 10 | ○ | 0.80 | ○ | ○ | △ |
| 11 | ○ | 0.72 | ◎ | ○ | ○ |
| 12 | △ (A Little Irregular) | 0.92 | ○ | ○ | ○ |
| 13 | ○ | 0.68 | ○ | ○ | ○ |
| 14 | △ (A Little Irregular) | 0.98 | ◎ | ○ | ○ |
| 15 | △ (A Little Cloudy) | 1.16 | ◎ | △ | ○ |
| 16 | ○ | 0.75 | ○ | ○ | ○ |
| 17 | ○ | 0.80 | ○ | ○ | ○ |
| 18 | ○ | 0.72 | ○ | ○ | ○ |
| 19 | ○ | 0.70 | ○ | ○ | ○ |
| 20 | ○ | 0.70 | ○ | ○ | ○ |
| 21 | ○～△ | 0.60 | ◎ | △ | ○ |
| 22 | ○ | 0.80 | ◎ | ○ | ○ |
| 23 | ○ | 0.70 | ○ | ○ | ○ |
| 24 | ○ | 0.83 | ○ | ○ | ○ |
| 25 | ○ | 0.63 | ◎ | ○～△ | ○ |
| 26 | ○ | 0.70 | ◎ | ○ | ○ |
| 27 | ○～△ (Slightly colloidal) | 0.93 | ◎ | ○ | ○ |
| 28 | ○ | 0.93 | ◎ | ○ | ○ |

- 30 -

It is added that properties of the films formed with the coating agents of Examples 29 - 37 were good, and all of anti-cracking, hardness and adhesiveness were satisfactory with the film thickness of $0.3\mu$ - $1.2\mu$.

By applying the coating agents of Examples 36 - 37 on the respective glass substrates according to the same treatment as in Test A, transparent and hard films without any cracking and having a thickness less than $0.1\mu$.

By applying the coating agent of Example 38 on the glass substrate as in Test A, a transparent film of $0.8\mu$ thickness was obtained.

In contrast therewith, the test results as to the films formed with the controls were not good as shown in Table 11.

Table 11

| Compar. Experim. No. | Properties of Formed Film | Thickness ($\mu$) | Anti-cracking | Hardness | Adhesive-ness |
|---|---|---|---|---|---|
| 1 | x (Exfoliated) | 0.93 | x | x | x |
| 2 | x | 0.37 | △ - x | △ | △ |
| 3 | ○ | 0.27 | ○ | ○ | ○ |
| 4 | x (Cloudy) | 0.54 | △ | x | x |
| 5 | x | 0.76 | x | x | x |
| 6 | x | 0.77 | x | x | x |
| 7 | x (Exfoliated) | 1.28 | x | x | x |
| 8 | x | 0.79 | x | △ - x | △ |
| 9 | x (Irregular, Cloudy) | 1.64 | x | x | x |
| 10 | x ( " ) | 0.97 | x | x | x |
| 11 | x ( " ) | 0.70 | △ | x | x |
| 12 | △ - x | 0.82 | x | △ - x | △ |

- 32 -

As seen from Table 11, the films formed with the coating agents obtained by subjecting the alkyl silicate to hydrolysis and condensation according to Comparative Experiments 1 - 3 showed cracking already with the thickness of $0.37\mu$. The properties, hardness and adhesiveness are not good.

As to the control comprising methanol silica-sol having 20 weight % $SiO_2$, which was prepared by distillation substitution of aqueous silica-sol according to Comparative Experiment 4, the film was opaque. Anti-cracking, hardness and adhesiveness were all unsatisfactory.

The coating agents obtained by mixing the organosilica-sol with the product prepared by hydrolyzing the alkyl silicate according to Comparative Experiment 5 and by further heating the same according to Comparative Experiment 6 were tested similar to those according to embodiments of the invention. Remarkably improvement of the invention can be appreciated particularly from said comparison.

The test results of the films formed with aqueous sol and alkyl silicate according to Experiment 7, by diluting the same according to Experiment 8, by mixing the hydrolyzate of the alkyl silicate with ethyl cellosolve silica-sol according to Experimnet 9, and by diluting the same according to Experiments 10 and 11 were all unsatispactory. The improvement made by the invention will be appreciated.

Test B

Coating agents according to some Examples and Comparative Experiments, each of about 20 ml, were contained in 50 ml brown ampules to be stored in the

- 33 -

chamber constantly held at a temperature of 50°C in order to study the storage stability, of which results are shown in Table 12.

Table 12

| | Storage Stability | |
|---|---|---|
| | 2 Weeks After | 1 Month After |
| Example 1 | ◯ | ◯ |
| " 2 | ◯ | ◯ |
| " 22 | ◯ | ◯ |
| " 28 | ◯ | ◯ |
| Comp.Exper.1 | x | x |
| " 7 | x | x |
| " 12 | x | x |

In the Table 12, x denotes ocurring of gells and ◯ dentoes no changes in the tested ciatubg agent.

Example 39

(1) Preparation Of Liquid Coating Agent

To a mixture of 208g tetraethyl orthosilicate and 270g ethanol, a mixture of 467g isopropanol silica-sol ($SiO_2$ Concentration of 30 weight %, Particle size of 70 - 100 m$\mu$), 54g water and 1g concentrated hydrochloric acid was dropwise added with stirring for 30 minutes, during which the reactant mixture temperature was raised from 21°C upto 30°C. After completion of said addition, the reactant mixture was heated at the reflux temeprature of the solvent for further 3 hours to obtain the liquid coating agent (A) having 20 weight % $SiO_2$.

- 34 -

(2)  Treatment For Smoothing Ceramic Substrate

After dipping an alumina substrate of 1 inch x 1 inch and about 0.6 mm thickness available in the market in said liquid coating agent, and taking up the substrate therefrom at a rate of 50 cm/min, the substrate aplied with the coating film was dried at 100°C for 30 minutes and calcinated in the electric furnace at 550°C for 2 hours to obtain the substrate having transparent and hard coating film showing no cracking nor exfoliation.

The surface roughness of said calcinated film formed on the alumina substrate was determined with an universal surface tester (MODEL SE-3C by Kosaka, Limited in Japan) according to JIS B0601 to show that Ra was $0.12\mu$.

Said Ra means a center line average roughness in the unit of $\mu$, and when extracting a measurement length, $\ell$ portion from the roughness curve in the center line direction, taking the center line of the extracted portion as X axis and the vertical magnification direction as Y axis, and further representing the roughness curve with y = f(x), it is given according to the following equality;

$$Ra - \frac{1}{\ell} \int_0^1 |f(x)| \, dx$$

When said substrate was dipped again in said liquid coating agent to be calcinated, said Ra value was $0.06\mu$.

Since material alumina substrate had a Ra value of $0.35\mu$, smoothness of the substrate can be considerably improved according to the invention.

Examples 40 - 45

- 35 -

(1) Preparation Of Liquid Coating Agents

Liquid Agent (B)

To a mixture of 208g tetraethyl orthosilicate, 233.5g methanol silica-sol ($SiO_2$ concentration of 30 weight %, particle size of 70 - 100 m$\mu$) and 233.5g ethyl cellosolve silica-sol ($SiO_2$ concetration of 30 weight %, particle size of 10 - 20 m$\mu$), a mixture of 270 g ethanol, 54g water and lg concentrated hydrochloric acid was dropwise added with stirring. The reaction mixture was heated at the reflux temperature of the solvent with stirring for 3 hours to obtain coating agent (B) containing 20 weight % $SiO_2$ to be used in following Example 40.

To a mixture of 152g tetramethyl orthosilicate, and 243g methanol, a mixture of isopropanol silica-sol ($SiO_2$ concentration of 30 weight %, particle size of 40 - 50 m$\mu$), 54g water and lg nitric acid was dropwise added with stirring at the reflux temperature of the solvent within 1 hour and then continuedly heated at the solvent reflux temperature for 2 hours to obtain coating agent (C) containing 20 weight % $SiO_2$ to be used in following Example 41.

Liquid Agent (D)

To a mixture of 150g Ethyl Silicate 40 available in the market and 498g ethanol, a mixture of 333g ethanol silica-sol ($SiO_2$ concentration of 30 weight %, particle size of 70 - 100 m$\mu$), 18g water and lg hydrochloric acid was dropwise added within 30 minutes. The reaction mixture was heated in the pressure resisting vessel at a temperature of 120°C for 1 hour to obtain coating agent (D) containing 16 weight % $SiO_2$ to be used in following Example 42.

- 36 -

Liquid Agent (E)

To a mixture of 208g tetraethyl orthosilicate and 245.5g ethanol, a mixture of 310g methyl isobutyl ketone silica-sol ($SiO_2$ concentration of 40 weight %, particle size of 10 - 20 m$\mu$), 36g water and 0.5g hydrochloric acid was dropwise added with stirring within 10 minutes. The reaction mixture was heated at the solvent reflux temperature for 5 hours to obtain coating agent (E) containing 23 weight % $SiO_2$ to be used in following Example 43.

Liquid Agent (F)

To a mixture of 208g tetraethyl orthosilicate and 70g isopropanol, a mixture of 667g ethanol silica-sol ($SiO_2$ concentration of 30 weight %, particle size of 70 - 100 m$\mu$), 54g water and 1g hydrochloric acid was dropwise added with stirring within 15 minutes. Then the reaction mixture was heated at the solvent reflux temperature for 3 hours to obtain coating agent (E) containing 26 weight % $SiO_2$ to be used in following Example 43.

Liquid Agent (G)

To a mixture of 208g tetraethyl orthosilicate and 100g ethyl cellosolve silica-sol ($SiO_2$ concentration of 30 weight %, particle size of 150 - 170 m$\mu$), a mixture of 386g ethanol, 54g water and 2g hydrochloric acid was dropwise added with stirring within 30 minutes. The reaction mixture was heated at the solvent reflux temperature for 1 hour to obtain coating agent (G) to be used in following Example 45.

(2) Treatment For Smoothing Ceramic Substrate

A porcelein enameled substrate and an alumina substrate of the same dimension as in Example 39 respectivley of the roughness (Ra) shown in Table 13 were formed with films from said liquid coating agents (A) - (G), of which roughnesses were as shown in said Table.

Comparative Experiments 13 - 14

(1) Preparation Of Liquid Coating Agents Control Liquid Agent (H)

To a mixture of 208g tetraethyl orthosilicate and 119g ethanol, a mixture of 72g water and 1g hydrochloric acid was dropwise added with stirring and ice cooling within 30 minutes. The reaction mixutre was heated at the solvent reflux temperature for 1 hour to obtain liquid agent (H) containing 15 weight % to be used in following Comparison Experiment 13.

Control Liquid Agent (I)

By adding 427g methanol, 200g acetone, 120g water and 0.05g nitric acid to 253g tetramethyl orthosilicate to be reacted, at 60°C for 20 hours to obtain coating agent (I) as control which contains 10 weight % $SiO_2$ and is used in following Comparative Experiment 14.

(2) Treatment For Smoothing Alumina Substrate

Alumina substrates of the same dimensions as in Example 39 but having Ra value of 0.32 were formed with films from said control agents (H) and (I) so as to determine the roughness.

The films formed by two times of coating, but the Ra value thereof was only 0.22. The smoothing treatment with such controls can not be said useful.

Table 13

| | Substrate | | Coating Agent | Application | One time Coating Film | | | Tow Times Coating Film | | |
|---|---|---|---|---|---|---|---|---|---|---|
| | Sort | Ra | | | Drying | Calcination | Ra | Drying | Calcination | Ra |
| Expl.39 | Alumina | 0.35 | A | Dipping, Taking Up 50 cm/min. | 100°C 30 min. | 550°C 2 hours | 0.12 | 100°C 30 min. | 550°C 2 hours | 0.06 |
| " 40 | Porcein | 0.35 | B | Spinner 2000 r.p.m. | 100°C 15 min. | 500°C 30 min. | 0.15 | 100°C 15 min. | 500°C 30 min. | 0.08 |
| " 41 | Alumina | 0.31 | C | Dipping, Taking Up 30 cm/min. | 200°C 10 min. | 500°C 30 min. | 0.18 | 200°C 10 min. | 500°C 30 min. | 0.10 |
| " 42 | Alumina | 0.30 | D | Spinner 2000 r.p.m. | 100°C 30 min. | 350°C 1 hour | 0.18 | 100°C 30 min. | 350°C 1 hour | 0.10 |
| " 43 | Alumina | 0.32 | E | Dipping, Taking Up 60 cm/min. | 100°C 30 min. | 500°C 30 min. | 0.15 | 100°C 30 min. | 500°C 30 min. | 0.06 |
| " 44 | Porcein | 0.38 | F | Spinner 2000 r.p.m. | 100°C 30 min. | 500°C 30 min. | 0.17 | 100°C 30 min. | 500°C 30 min. | 0.08 |
| " 45 | Alumina | 0.27 | G | Dipping, Taking Up 45 cm/min. | 150°C 30 min. | 500°C 30 min. | 0.14 | 150°C 30 min. | 500°C 30 min. | 0.07 |
| Comp. Exp. 13 | Alumina | 0.32 | H | Dipping, Taking Up 45 cm/min. | 100°C 30 min. | 500°C 30 min. | 0.28 | 100°C 30 min. | 500°C 30 min. | 0.22 |
| " 14 | Alumina | 0.32 | I | Dipping, Taking Up 25 cm/min. | 150°C 10 min. | 400°C 30 min. | 0.27 | 150°C 10 min. | 400°C 30 min. | 0.22 |

0206717

- 39 -

Example 46

Said liquid coating agents A - G according to the invention and H - I as controls were contained in the respective sealed vessels to be held at a temperature of 20°C for the stability test.

The coating agents H and I were gelated like as agar in one month, but all of the coating agents A - G showed no increase of viscosity even after the lapse of three months.

Similar to Example 39 calcinated coating films were formed with said coating agents A - G stored for three months on the respective alumina substrates. The films were readily formed and showed satisfactory properties as in Example 39.

- 40 -

What is claimed is;

1.    Coating composition to be obtained by reacting 100 parts by weight as $SiO_2$ of an organosilica-sol, which contains colloidal silica of 5 - 200 m$\mu$, and more particularly of 50 - 100 m$\mu$, particle size dispersed in an organic solvent in the amount of 1 - 50 weight % as $SiO_2$, in an amount of 100 weight % as $SiO_2$, 20 - 200 weight parts as $SiO_2$ of an alkyl silicate; and 0.5 - 7 mol of water relative to 1 gram atom of silicon in said alkyl silicate.

2.    Coating composition as claimed in Claim 1, in which said organic solvent is any selected from a class consisting of alcohols, ketones, ethers, esters, aliphatic and aromatic hydrocarbons and homogeneous mixtures thereof.

3.    Coating composition as claimed in Claim 2, in which said organic solvent is any selected from a class consisting of methanol, ethanol, isopropanol, butanol, acetone, methyl ethyl ketone, methyl isobutyl ketone, diisopropyl ether, methyl cellosolve, ethyl cellosolve, propyl cellosolve, methyl acetate, ethyl acetate, butyl acetate, hexane, heptane, benzene, toluene and xylene.

4.    Coating composition as claimed in any of said Claims 1 - 3, in which said alkyl silicate is any selected from a class consisting of tetramethyl orthosilicate, tetraethyl orthosilicate, tetra-n-propyl orthosilicate, tetra-i-propyl orthosilicate, tetra-n-

- 41 -

butyl-orthosilicate, tetra-sec-butyl orthosilicate,
methyl polysilicate of 2 - 10 condensation degree,
ethyl polysilicate of 2 - 10 condensation degree, and a
mixture thereof.

5.    Coating composition as claimed in any of said
Claims 1 - 4, in which the reaction is carried out at a
temperature between 40°C and a boiling point of said
solvent under the atmospheric pressure.

6.    Coating composition as claimed in any of said
Claims 1 - 5, which comprises 0.1 - 15 weight % $SiO_2$
derived from said alkyl silicate.

7.    Coating composition as claimed in any of said
Claims 1 - 6, in which the reaction is carried out in
the presence of a catalyst selected from a class
consisting of hydrogen chloride, sulphuric acid, nitric
acid, phosphoric acid, boric acid, formic acid, acetic
acid, oxalic acid, benzoic acid, methanesulfonic acid,
paratoluene sulfonic acid and an mixture thereof.

8.    Ceramic substrate coated with coating agent
according to any of Claims 1 - 7, dried and calcinated.

9.    Ceramic substrate as claimed in Claim 8, in which
said substrate is made of any selected from a class
consisting of alumina, berylia, magnesia, mullite,
steatite, forsterite, porcelain enameled, silicon
nitride, aluminum nitride and silicon carbide.